# EUROPEAN PATENT APPLICATION

(11) **EP 2 048 929 A1**
(43) Date of publication of application: **15.04.2009**
(21) Application number: 07713835.2
(22) Date of filing: 06.02.2007
(51) Int. Cl.: H05K 9/00, G09F 9/00

(54) **METHOD FOR MANUFACTURING OPTICAL FILTER FOR DISPLAY, OPTICAL FILTER FOR DISPLAY, AND DISPLAY AND PLASMA DISPLAY PANEL PROVIDED WITH SUCH OPTICAL FILTER**

(30) Priority: 08.02.2006 JP 2006030444; 18.01.2007 JP 2007009048
(71) Applicant: Bridgestone Corporation, Tokyo 104-0031 (JP)
(72) Inventor: SUGIMACHI, Masato, Yokohama-shi, Kanagawa 2448510 (JP); ISHII, Yorinobu, Yokohama-shi, Kanagawa 2448510 (JP)
(74) Representative: Whalley, Kevin
(86) International application number: PCT/JP2007/051993
(87) International publication number: WO 2007/091545

(57) **Abstract**

[Problem to be solved]

To provide a process for the preparation of an optical filter for display provided with ground electrode portion having excellent productivity, and an optical filter for display.

[Means for solving problem]

A process for the preparation of an optical filter for display having a protruding conductive layer in its periphery as an electrode portion, comprising: forming a metal conductive layer provided on a whole surface of a rectangle-shaped transparent film, forming a functional layer containing synthesis resin provided on the rectangle-shaped the metal conductive layer, and irradiating with laser an edge area or an area adjacent to the edge area of all four sides of a rectangle-shaped functional layer to remove the irradiated portion of the functional layer; and an optical filter advantageously obtained from the process.

## Description

### Background of Invention

### 1. Field of the invention

The present invention relates to an optical filter for adding various functions such as antireflection, near-infrared shielding and electromagnetic wave shielding to various displays such as plasma display panel (PDP), cathode-ray-tube (CRT) display, liquid crystal display, organic EL (electroluminescence) display and field emission display (FED) including surface-conduction electron-emitter display (SED), and a display provided with the optical filter, particularly PDP.

### 2. Description of the Related Art

In flat-panel displays such as liquid crystal display, plasma display panel (PDP) and organic EL display, and CRT display, the problem that external light is reflected on a surface of the display to have difficult seeing visual information of the display has been known. Therefore, various countermeasures including provision of various optical films such as an antireflection film on the displays are taken.

In recent years, image magnification has entered the mainstream of the displays, and PDP has been generalized as a next-generation device for image magnification. However, high-frequency pulse discharge is carried out in the light emitting part of the PDP for image display, and therefore unnecessary electromagnetic waves or infrared rays causing malfunction of infrared remote control are possibly radiated. Thus, as for the PDP, various antireflection films (electromagnetic-wave shielding and light transmitting plates) having electric conductivity for PDP are proposed. Examples of the electromagnetic-wave shielding and light transmitting plates include (1) a transparent film having a metallic silver-containing transparent conductive thin layer thereon; (2) a transparent film having a conductive mesh layer consisting of network-patterned metallic wire or conductive fiber thereon; (3) a transparent film having network-patterned copper foil layer obtained by etching-processing copper foil so as to have opening parts thereon; (4) a transparent film having mesh-shaped conductive ink formed by printing thereon.

Further, onto conventional large-size displays including PDP, various optical films such as an antireflection film and a near-infrared cut film are attached. For example, patent document 1 (JP11-74683-A) describes an electromagnetic-wave shielding and light transmitting plate obtained by placing a conductive mesh layer between two transparent plates and bonding them by transparent adhesive resin to unit them.

In order to enhance electromagnetic-wave shielding property of the conductive layer, the electromagnetic-wave shielding and light transmitting plate (laminate) requires that the conductive layer such as a conductive mesh layer is connected to a body of PDP (i.e., grounded). For the grounding, it is necessary to protrude the electromagnetic-wave shielding material outward between the two transparent plates to extend it to backside of the laminate to ground it, or to insert a conductive adhesive tape between the two transparent plates so as to be in contact with the electromagnetic-wave shielding material. However, such ways render operations of the laminating process troublesome

Further, patent document 2 (JP2001-142406-A) describes an electromagnetic-wave shielding and light transmitting plate comprising a laminate obtained by superposing a transparent plate, an electromagnetic-wave shielding material, an antireflection film and a near-infrared cut film, the antireflection film being arranged at the top of the laminate, to unite them, wherein a conductive adhesive tape is attached onto both sides of the transparent plate through its side, and the conductive adhesive tape and the electromagnetic-wave shielding material are bonded to each other by the conductive adhesive.

Patent document 1: JP11-74683-A
Patent document 2: JP2001-142406-A

### Summary of the Invention

### Problem to be solved by the Invention

For example, in case an optical filter for display such as PDP is prepared using a continuous plastic film, a near-infrared cut film and an antireflection film are prepared respectively, these films are laminated through a conductive mesh layer for electromagnetic-wave shielding to prepare a continuous optical filter and then cutting it in accordance with the shape of the front surface of the display. Therefore the continuous optical filter is generally cut in the width direction. The side cut in the width direction, and in the cut surface (side), all the layers are exposed, but the exposed portion of the cut sides have only extremely small areas. The conductive mesh layer also have only extremely small exposed edge side (area).

It is difficult to use the above-mentioned optical filter as it is, and to ground the filter by means of the exposed conductive layer (e.g., conductive mesh layer) to render the electromagnetic-wave shielding property excellent.

Even if one transparent plate is used, the optical filter described in patent document 2 requires that all layers constituting the filter are bonded to one another so as to protrude the conductive mesh layer from the side of the filter. Such operation is troublesome.

Thus, the object of the present invention is to provide a process for the preparation of an optical filter for display which has excellent electromagnetic-wave shielding property, which can be easily attached to a display, and whose ground electrode can be easily grounded, and by which the optical filter can be easily prepared.

Further, the object of the present invention is to provide a process for the preparation of an optical filter for display which is lightweight and thin, which has excellent electromagnetic-wave shielding property, which can be easily attached to a display, and whose ground electrode can be easily grounded, and by which the optical filter can be easily prepared.

Furthermore, the object of the present invention is to provide an optical filter for display which can be easily prepared, which has excellent electromagnetic-wave shielding property, which can be easily attached to a display, and whose ground electrode can be easily grounded.

Moreover, the object of the present invention is to provide an optical filter for display which can be easily prepared, which is lightweight and thin, which has excellent electromagnetic-wave shielding property, which can be easily attached to a display, and whose ground electrode can be easily grounded.

Further, the object of the present invention is to provide an optical filter suitable for PDP which can be easily prepared, which has excellent electromagnetic-wave shielding property, which can be easily attached to a display, and whose ground electrode can be easily ground, and can be easily prepared.

Furthermore, the object of the present invention is to provide a display in which the optical filter having excellent characteristics is attached onto a surface of a glass plate for image display of the display.

Still, the object of the present invention is to provide a PDP in which the optical filter having excellent characteristics is attached onto a surface of a glass plate for image display of the PDP.

### Means for solving problem

Thus, the present invention can be provided by an optical filter for display comprising a structure of a metal conductive layer provided on a (one) transparent film,
wherein a first functional layer is provided on the metal conductive layer of the transparent film, and the metal conductive layer is exposed in at least a part of a peripheral edge area or an area adjacent to said edge area of the transparent film.

The embodiments of the optical filter for display according to the present invention are described as follows:
(1) A second functional layer is provided on a surface (side) having no metal conductive layer of the transparent film.
(2) The transparent film has shape of rectangle, the metal conductive layer is provided on a whole surface of the transparent film, the first functional layer is provided on an area except an edge area of at least both sides of the metal conductive layer, and the metal conductive layer is exposed in the edge area of at least both sides.
(3) The transparent film has shape of rectangle, the metal conductive layer is provided on a whole surface of the transparent film, a band-shaped first functional layer is provided on an edge area of at least both sides of the metal conductive layer, a band-shaped metal conductive layer having no first functional layer is exposed in an adjoining area inside the band-shaped first functional layer, and the first functional layer is provided on a central portion inside (surrounded by) the band-shaped exposed metal conductive layer.
(4) The exposed metal conductive layer is a continuous band-shaped area, or an intermittent continuous band-shaped area consisting of island-shaped conductive layers interrupted by the first functional layer.
(5) The exposed metal conductive layer is formed in an edge area of four sides of the first functional layer to have shape of frame.
(6) The metal conductive layer is a mesh-shaped metal conductive layer.
(7) The first functional layer is a hard coat layer.
(8) The first functional layer comprises a hard coat layer and a low refractive index layer having lower refractive index than that of the hard coat layer, the hard coat layer being in contact with the metal conductive layer. Thereby excellent antireflection property can be obtained.
(9) The first functional layer comprises a hard coat layer, a high refractive index layer having higher refractive index than that of the hard coat layer and a low refractive index layer having lower refractive index than that of the hard coat layer, the hard coat layer being in contact with the metal conductive layer. Thereby more excellent antireflection property can be obtained.
(10) The first functional layer is an anti-glare layer. The anti-glare layer generally shows excellent antireflection property, and brings about, in many cases, the effect of no provision of the antireflection layers mentioned in (7) to (9). The provision of the anti-glare layer enhances freedom degree with respect to selection of refractive index of other layers to broaden the options of materials of the layers, whereby reduction of cost can be also obtained.
(11) The first functional layer comprises an anti-glare layer and a low refractive index layer having lower refractive index than that of the anti-glare layer, the anti-glare being in contact with the metal conductive layer. Thereby further excellent antireflection property can be obtained compared with only an anti-glare layer.
(12) The second functional layer is at least one layer selected from a near-infrared absorption layer, a neon-cut layer and a transparent adhesive layer. It is preferred that the second functional layer is a transparent adhesive layer having near-infrared absorption function and neon-cut function; that the second functional layer comprises a near-infrared absorption layer having neon-cut function and a transparent adhesive layer, superposed in this order on the transparent film; that the second functional layer comprises a near-infrared absorption layer and a transparent adhesive layer having neon-cut function, superposed in this order on the transparent film; or that the second functional layer comprises a near-infrared absorption layer, a neon-cut layer and a transparent adhesive layer, superposed in this order on the transparent film.
(13) The exposed metal conductive layer is an intermittent continuous band-shaped area consisting of island-shaped conductive layers interrupted by the first functional layer, shapes of the island-shaped conductive layers being the same as or different from each other.
(14) The openings of the mesh-shaped metal conductive layer are filled with the hard coat layer. Thereby excellent transparency can be obtained.
(15) The transparent film is a plastic film.
(16) A release sheet is provided on the transparent adhesive layer. It becomes easy to attach the optical filter onto a display.
(17) The optical filter for display is an optical filter for plasma display panel.
(18) The optical filter for display is attached onto a glass plate.

Further, the present invention is provided by a process for the preparation of an optical filter for display having a protruding conductive layer in its periphery as an electrode portion, comprising:
a step of irradiating with laser at least a part of a periphery edge area or an area adjacent to said edge area of a first functional layer of a laminate, the laminate comprising a transparent film, a metal conductive layer provided on a whole surface of the transparent film and the first functional layer provided on a whole surface of the metal conductive layer, to remove the irradiated portion of the first functional layer whereby the metal conductive layer is exposed in the portion;
a process for the preparation of an optical filter for display having a protruding conductive layer in its periphery as an electrode portion, comprising:
a step of irradiating with laser an edge area or an area adjacent to the edge area of at least both sides of a rectangle-shaped first functional layer of a laminate, the laminate comprising a rectangle-shaped transparent film, a metal conductive layer provided on a whole surface of the transparent film and the first functional layer provided on a whole surface of the metal conductive layer, to remove the irradiated portion of the rectangle-shaped first functional layer whereby a band-shaped metal conductive layer is exposed in the irradiated portion (i.e., the edge area or the area adjacent to the edge area of at least both sides of the rectangle-shaped first functional layer); and
a process for the preparation of an optical filter for display having a protruding conductive layer in its periphery as an electrode portion, comprising:
a step of irradiating with laser an edge area or an area adjacent to the edge area of all four sides of a rectangle-shaped first functional layer of a laminate, the laminate comprising a rectangle-shaped transparent film, a metal conductive layer provided on a whole surface of the transparent film and the first functional layer provided on a whole surface of the metal conductive layer, to remove the irradiated portion of the first functional layer whereby a frame-shaped metal conductive layer is exposed in the irradiated portion (i.e., the edge area or the area adjacent to the edge area of the rectangle-shaped first functional layer).

The embodiments of the process for the preparation of optical filter for display according to the present invention are described as follows:
(1) A second functional layer is provided on a surface (side) having no metal conductive layer of the transparent film.
(2) The irradiation of the laser is carried out continuously or intermittently.

The embodiments mentioned in the optical filter of the invention can be used as those of the process of the invention.

The present invention is provided by an optical filter for display obtained by the process for the preparation of an optical filter for display as defined above; and
an optical filter for display obtained by the process for the preparation of an optical filter for display as defined above, which is attached onto a glass plate.

Further, the present invention is provided by a display provided with the optical filter for display as defined above (the optical filter is generally attached onto an image display glass plate); and
a plasma display provided with the optical filter for display as defined above (the optical filter is generally attached onto an image display glass plate).

The optical filter for display is preferably attached onto a surface of an image display glass plate such that a surface having no conductive layer of the optical filter us in contact with the surface of the glass plate.

### Effect of the Invention

According to the process for the preparation of an optical filter for display of the present invention, an optical filter for display having a protruding conductive layer in its periphery as an electrode portion (ground electrode) can be extremely easily prepared. In more detail, a first functional layer is provided on a whole surface of the metal conductive layer provided on a whole surface of the transparent film, and an edge area or an area adjacent to the edge area of the rectangle-shaped first functional layer is irradiated with laser to remove the irradiated portion of the first functional layer to expose a conductive layer in the irradiated portion, whereby the optical filter for display having a protruding conductive layer in its periphery as an electrode portion (ground electrode) can be obtained. By the process, the optical filter for display having a protruding conductive layer in its periphery as an electrode portion can be extremely easily prepared, and the provision of the electrode renders earth ground easy.

Further, the optical filter for display of the invention is an optical filter provided with a ground electrode made of a conductive layer having a specific structure, which can be advantageously obtained by the process mentioned above. The optical filter has advantage that a ground electrode can be easily provided as mentioned above.

Particularly, in case of using one transparent film to prepare an optical filter, the resultant optical filter has an extremely small thickness and its weight is decreased with the reduction of thickness. Therefore the optical filter can be easily handled before, during and after attachment of the filter onto the display.

Thus the optical filter for display of the invention filter is capable of adding various functions such as antireflection, near-infrared shielding and electromagnetic wave shielding to various displays such as plasma display panel (PDP), cathode-ray-tube (CRT) display, liquid crystal display, organic EL (electroluminescence) display, field emission display (FED) including surface-conduction electron-emitter display (SED), and shows high productivity.

### Brief Description of the Drawings

[Fig. 1] Fig. 1 is a view for explaining an example of the process for the preparation of the optical filter for display provided with electrode portion according to the present invention.
[Fig. 2] Fig. 2 is a schematic section view showing a typical example of the optical filter for display provided with electrode portion according to the present invention.
[Fig. 3] Fig. 3 is a plain view of the optical filter for display provided with electrode portion shown in Fig. 2.
[Fig. 4] Fig. 4 is a partial plain view of another embodiment of the optical filter for display provided with electrode portion shown in Fig. 2.
[Fig. 5] Fig. 5 is a schematic section view showing an example of preferred embodiment of the optical filter for display provided with electrode portion according to the present invention.
[Fig. 6] Fig. 6 is a view for explaining an example of another embodiment of the process for the preparation of the optical filter for display provided with electrode portion according to the present invention.
[Fig. 7] Fig. 7 is a schematic section view showing an example of another embodiment of the optical filter for display provided with electrode portion according to the present invention.
[Fig. 8] Fig. 8 is a plain view of the optical filter for display provided with electrode portion shown in Fig. 7.
[Fig. 9] Fig. 9 is a partial plain view of another embodiment of the optical filter for display provided with electrode portion shown in Fig. 7.
[Fig. 10] Fig. 10 is a schematic section view showing an example of preferred embodiment of the optical filter for display provided with electrode portion according to the present invention.
[Fig. 11] Fig. 11 is a schematic section view showing an example of the condition that the optical filter is attached onto an image display surface of a plasma display panel.

### Explanation of reference number

- 12, 22, 32, 42: Transparent film
- 13, 23, 33, 43: Metal conductive layer
- 13', 23', 33', 43': Exposed area of metal conductive layer
- 16, 26, 36, 46: Hard coat layer
- 16', 26': Edge-area hard coat layer
- 24, 47: Low refractive index layer
- 27': Edge-area low refractive index layer
- 14, 24, 34, 44: Near-infrared absorption layer
- 15, 25, 35, 45: Transparent adhesive layer

### Description of Preferred Embodiments

The process for the preparation of an optical filter for display provided with an electrode portion (ground electrode) according to the present invention, and the optical filter for display provided with an electrode portion are explained in detail below.

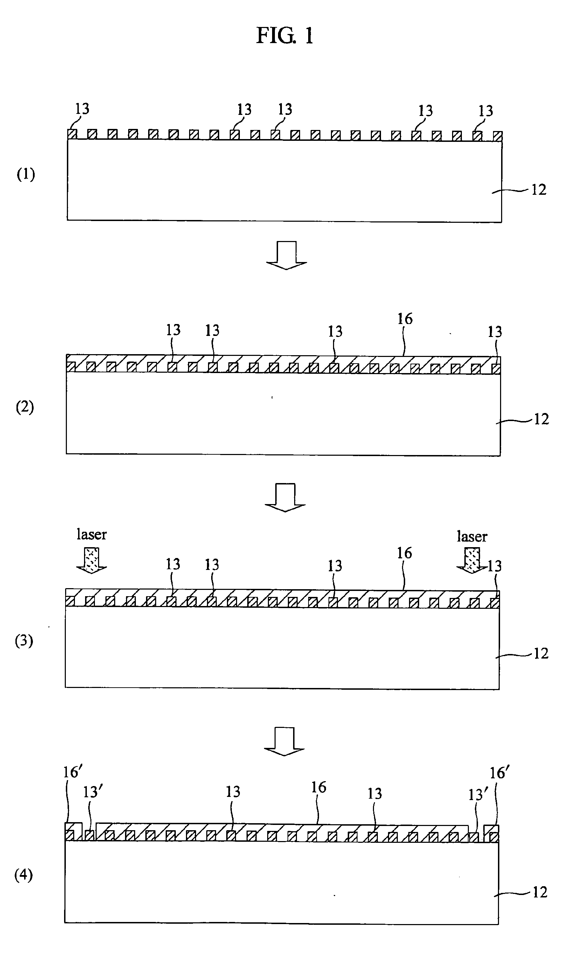

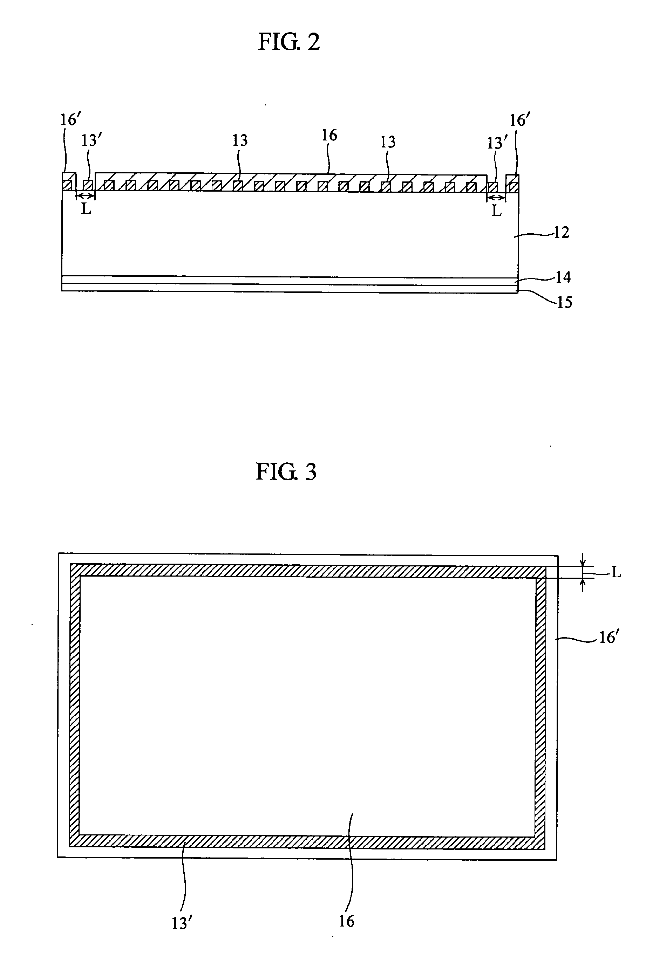

A schematic section view for explaining an example of the process for the preparation of the optical filter for display provided with electrode portion according to the present invention is shown in Fig. 1. A mesh-shaped metal conductive layer 13 is formed on a whole surface of a rectangle-shaped transparent film 12 (step 1), and subsequently a hard coat layer 16 comprising synthetic resin as a first functional layer is formed on a whole surface of the mesh-shaped metal conductive layer 13 (step 2). Thereafter, a nearly edge area of four sides (i.e., whole periphery) of the rectangle-shaped hard coat layer 16 is irradiated with laser (step 3). The irradiation may be carried out on only the both sides of the rectangle-shaped hard coat layer 16. The irradiation of laser is carried out in an area except the edge (farthest edge). Since the hard coat layer 16 comprises synthetic resin, the hard coat layer 16 in the area that has been irradiated with laser decomposes or burns to disappear. Thereby the hard coat layer 16 in the area adjacent to the edge area of four sides is removed to expose the metal conductive layer, whereby an exposed area of metal conductive layer 13' is formed and this area constitutes an electrode portion (step 4). In the process, the hard coat layer in the (farthest) edge area is not irradiated with laser, and hence the hard coat layer remaining in the edge area constitutes an edge-area hard coat layer 16'. Thereafter, a near-infrared absorption layer 14 as a second functional layer is generally formed on a back side (generally whole surface) of the transparent film 12, and a transparent adhesive layer 15 is formed on the near-infrared absorption layer 14, whereby an optical filter corresponding to one of the preferred embodiments of the invention can be obtained as shown in Fig. 2. The transparent adhesive layer 15 may not be provided. Otherwise, the hard coat layer may be formed on the transparent film 12 having the near-infrared absorption layer 14 and the transparent adhesive layer 15 provided preliminarily. Various conductive materials can be connected to the electrode portion (exposed area of metal conductive layer 13') to connect to ground. The hard coat layer is shown as one of the first functional layer.

The first or second functional layer includes any layer showing any function and comprising synthetic resin. In the invention, the first functional layer generally consists of a hard coat layer; or a hard coat layer and a low refractive index layer having lower refractive index than that of the hard coat layer, the hard coat layer being in contact with the metal conductive layer; or a hard coat layer, a high refractive index layer having higher refractive index than that of the hard coat layer and a low refractive index layer having lower refractive index than that of the hard coat layer, the hard coat layer being in contact with the metal conductive layer. A better antireflection property is obtained as the number of the layer is increased. Otherwise, the first functional layer preferably consists of an anti-glare layer; or an anti-glare layer and a low refractive index layer having lower refractive index than that of the anti-glare layer, the anti-glare being in contact with the metal conductive layer. The anti-glare layer generally shows excellent antireflection property, and brings about, in many cases, the effect of no provision of the antireflection layers. The provision of the anti-glare layer enhances freedom degree with respect to selection of refractive index of other layers to broaden the options of materials of the layers, whereby reduction of cost can be also obtained. In the case of combination of an anti-glare layer and a low refractive index layer having lower refractive index, further excellent antireflection property can be obtained compared with only an anti-glare layer.
The second functional layer generally is a near-infrared absorption layer, a neon-cut layer or a transparent adhesive layer, or a combination of two or more layers of these layers. In the invention, the second functional layer is preferably composed of a transparent adhesive layer having near-infrared absorption function and neon-cut function; or a near-infrared absorption layer having neon-cut function and a transparent adhesive layer, superposed in this order on the transparent film; or a near-infrared absorption layer and a transparent adhesive layer having neon-cut function, superposed in this order on the transparent film; or a near-infrared absorption layer, a neon-cut layer and a transparent adhesive layer, superposed in this order on the transparent film.

In Fig. 1 and Fig. 2, though the edge area of four sides (i.e., whole periphery) of the rectangle-shaped hard coat layer 16 is irradiated with laser, the edge area of at least both sides of the rectangle-shaped hard coat layer 16 may be irradiated with laser to form the exposed area of metal conductive layer 13' in the edge area of at least both sides. As for the laser, one laser may be used to irradiate the periphery or both sides. Otherwise plural lasers may be used to irradiate each of the sides. Thus irradiation methods of laser can be appropriately varied.

A plane view of the preferred example shown in Fig. 2, which has the exposed area of metal conductive layer 13' in the form of frame formed on the whole periphery of the hard coat layer 16 and the edge-area hard coat layer 16' in the form of frame formed outside the exposed area of metal conductive layer 13', is shown in Fig. 3.

In the preparation of the optical filter having the exposed area of metal conductive layer 13' in the whole periphery as shown in Fig. 2 and Fig. 3, the optical filter may be prepared with respect to each sheet (batch-wise), but it is possible to continuously prepare the optical filter in the following manner. A hardcoat layer 16 is formed on a continuous transparent film 12 having a mesh-shaped metal conductive layer 13, and the edges of the both sides are irradiated with laser to form an exposed area of metal conductive layer 13' in the both edges, and subsequently the continuous transparent film 12 is cut, and the edges of the cut both sides is irradiated with laser to form an exposed area of metal conductive layer 13' whereby a frame-shaped exposed area of metal conductive layer 13' is formed to provide an optical filter having the exposed area of metal conductive layer 13' in the whole periphery.

The exposed area of metal conductive layer 13' is used as an electrode portion for ground. The width of the band-shaped area in the both sides (L in Fig. 2 and Fig. 3) is generally in the range of 1 to 100mm, especially 2 to 50mm. Further, the width of the band-shaped area of the edge-area hard coat layer 16' is generally in the range of 0.1 to 20mm, especially 0.5 to 5mm.

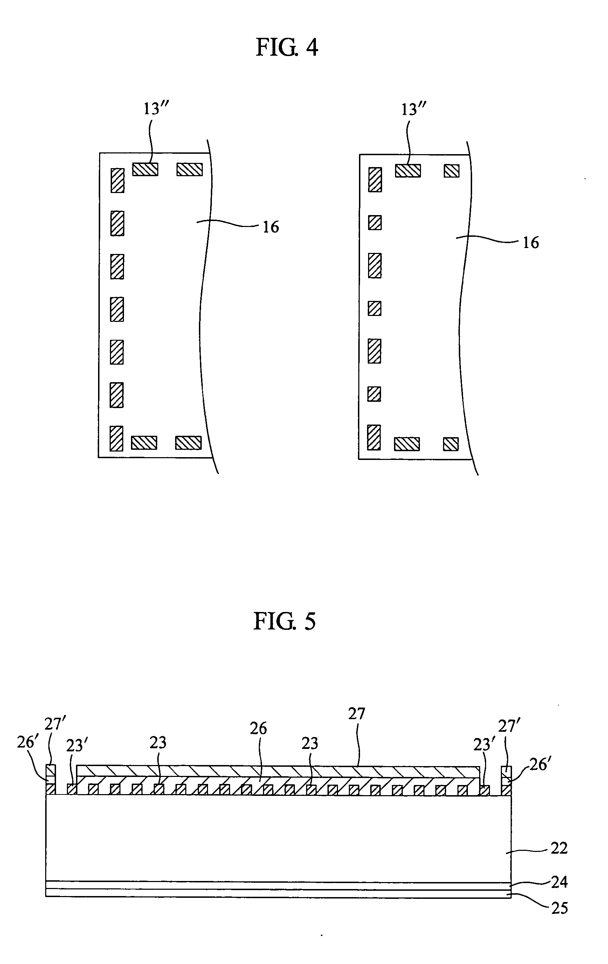

Though the exposed area of metal conductive layer 13' shows band-shaped area, the invention includes any exposed metal conductive layer capable of forming electrode portion in the edges. Therefore, the exposed area of metal conductive layer 13' may be an intermittent band-shaped area in which island-shaped areas 13" are continuously provided, as shown in the partial view of Fig. 4. The shape of the island-shaped areas 13" may be any shape such as rectangle, ellipse, circle, polygon. The sizes of island-shaped areas 13" are the same as each other or different from each other.

On the hard coat layer 16, a low refractive index layer having lower refractive index than that of the hard coat layer is preferably provided in order to enhance antireflection property. In the case, the low refractive index layer is generally formed on the whole surface of the hard coat layer. Provision of the hard coat layer and the low refractive index layer is performed by coating and (light) curing each layer separately, or by coating and then (light) curing these layers at a time. Though the hard coat layer 16 is provided on the metal conductive layer, an anti-glare layer and if desired the low refractive index layer is also preferably provided on the metal conductive layer depending on desired design of the optical filter. The anti-glare layer is preferably a hard coat layer having antiglare function.

An example of a schematic section view of an optical filter having the structure that a low refractive index layer (antireflection layer) is further provided on the hard coat layer of the optical filter of the invention as shown in Fig. 2 is shown in Fig. 5. In Fig. 5, a mesh-shaped metal conductive layer 23, a hard coat layer 26 and a low refractive index layer 27 are provided on one surface of a transparent film 22 in this order, and a near-infrared absorption layer 24 and a transparent adhesive layer 25 are provided on the other surface of the transparent film 22 in this order. The area adjacent to the edge area of the surface of low refractive index layer 27 is irradiated with laser. As for the hard coat layer 26, an edge-area hard coat layer 26' is provided in an edge area outside an exposed area of metal conductive layer 23', and as for the low refractive index layer 27, an edge-area low refractive index layer 27' is provided on the edge-area hard coat layer 26' in the edge area outside an exposed area of metal conductive layer 23'. Any layers (e.g., high refractive index layer) provided on the hard coat layer 26 (26') are provided on the central area and the edge area as well as the low refractive index layer. Further, openings of the mesh-shaped metal conductive layer 24 are filled with the hard coat layer. Thereby the transparency is enhanced. The mesh-shaped metal conductive layer 14 is the same as 24. As mentioned above, an antiglare layer is also preferably provided instead of the hard coat layer 26.

In the above-mentioned structure, the hard coat layer 26 and the low refractive index layer (antireflection layers) 27 may be replaced in the location with the near-infrared absorption layer 24 each other. Further, the near-infrared absorption layer 24 may be provided between the metal conductive layer 23 and the hard coat layer 26. However, the structure of Fig. 5 is advantageous in easiness of provision of ground because, after attachment of the optical filter to a display, the conductive layer is located in front side (obverse side) of the display.

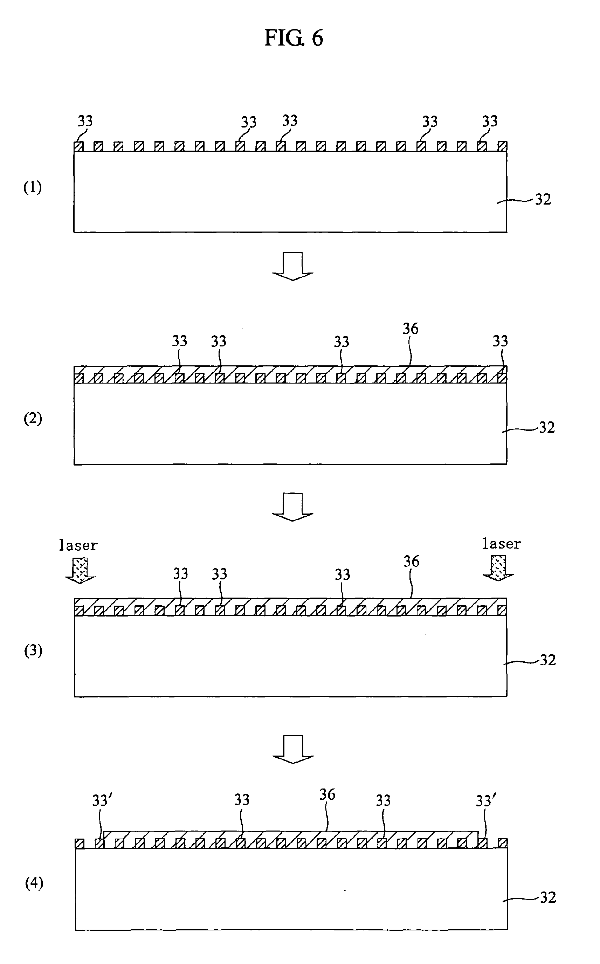

In Fig. 1 to Fig. 5, the embodiment that the exposed area of metal conductive layer is provided in the nearly edge area having the edge-area hard coat layer outside the exposed area has been explained. The invention includes the embodiment having no edge-area hard coat layer, that is the embodiment having the exposed area of metal conductive layer in the farthest edge area. Such the embodiment is explained by referring the following Fig. 6 to Fig. 10.

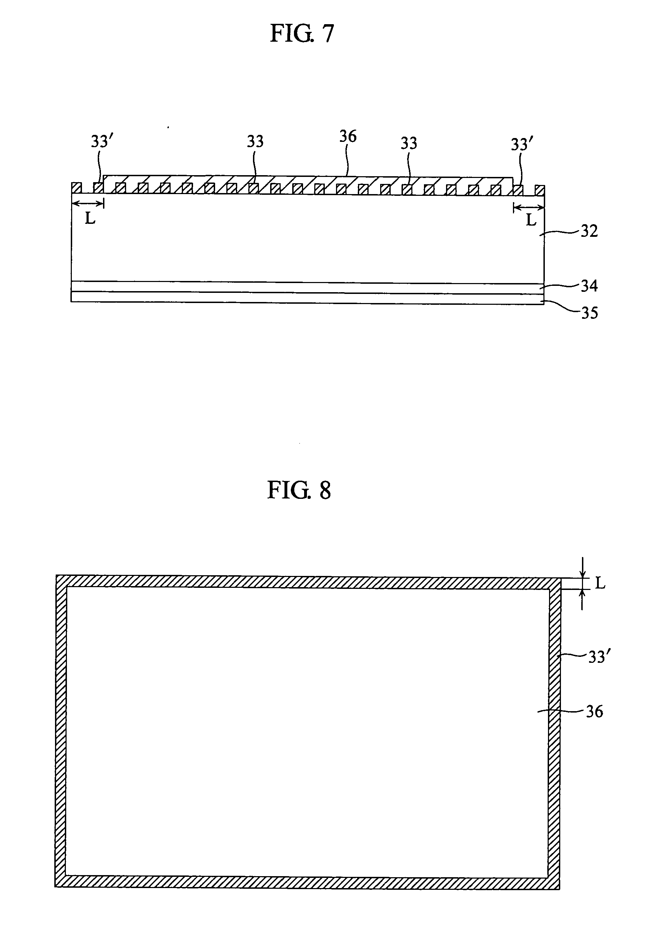

A schematic section view for explaining another example of the process for the preparation of the optical filter for display provided with electrode portion according to the present invention as mentioned above is shown in Fig. 6. A mesh-shaped metal conductive layer 33 is formed on a whole surface of a rectangle-shaped transparent film 32 (step 1), and subsequently a hard coat layer 36 comprising synthetic resin as a first functional layer is formed on a whole surface of the mesh-shaped metal conductive layer 33 (step 2). Thereafter, an edge area of four sides (or both sides) of the rectangle-shaped hard coat layer 36 is irradiated with laser (step 3). Since the hard coat layer 36 comprises synthetic resin, the hard coat layer 36 in the area that is irradiated with laser decomposes or burns to disappear. Thereby the hard coat layer 36 in the edge area of four sides is removed to expose the metal conductive layer, whereby an exposed area of metal conductive layer 33' is formed and this area constitutes an electrode portion (step 4). In case the irradiation of laser is carried out so as not to remain an edge-area hard coat layer, it is necessary to be careful not to soften the transparent film. Thereafter, a near-infrared absorption layer 34 as a second functional layer is generally formed on a back side (generally whole surface) of the transparent film 32, and a transparent adhesive layer 35 is formed on the near-infrared absorption layer 34, whereby an optical filter corresponding to one of the preferred embodiments of the invention can be obtained as shown in Fig. 7. The transparent adhesive layer 35 may not be provided. Otherwise, the hard coat layer may be formed on the transparent film 32 on which the near-infrared absorption layer 34 and the transparent adhesive layer 35 have been provided preliminarily. Various conductive materials can be connected to the electrode portion (exposed area of metal conductive layer 33') to connect to ground.

In Fig. 6 and Fig. 7, though the edge area of four sides (i.e., whole periphery) of the rectangle-shaped hard coat layer 36 is irradiated with laser, the edge area of at least both sides of the rectangle-shaped hard coat layer 36 may be irradiated with laser to form the exposed area of metal conductive layer 33' in the edge area of at least both sides. As for the laser, one laser may be used to irradiate the periphery or both sides. Otherwise plural lasers may be used to irradiate each of the sides. Thus irradiation methods of laser can be appropriately varied.

A plane view of the preferred example shown in Fig. 7, which has the exposed area of metal conductive layer 33' in the form of frame formed on the whole periphery of the hard coat layer 36, is shown in Fig. 8.

In the preparation of the optical filter having the exposed area of metal conductive layer 33' in the whole periphery as shown in Fig. 6 and Fig. 7, the optical filter may be prepared with respect to each sheet (batch-wise), but it is possible to continuously prepare the optical filter in the following manner. A hardcoat layer is formed on a continuous transparent film 32 having a mesh-shaped metal conductive layer 33, and the edges of the both sides are irradiated with laser to form an exposed area of metal conductive layer 33' in the both edges, and subsequently the continuous transparent film 12 is cut, and the edges of the cut both sides is irradiated with laser to form an exposed area of metal conductive layer 33' whereby a frame-shaped exposed area of metal conductive layer 33' is formed to provide an optical filter having the exposed area of metal conductive layer 33' in the whole periphery.

The exposed area of metal conductive layer 33' is used as an electrode portion for ground. The width of the band-shaped area in the both sides (L in Fig. 7 and Fig. 8) is generally in the range of 2 to 100mm, especially 5 to 50mm. Further, the width of the band-shaped area of the edge-area hard coat layer 16' is generally in the range of 0.1 to 20mm, especially 0.5 to 5mm.

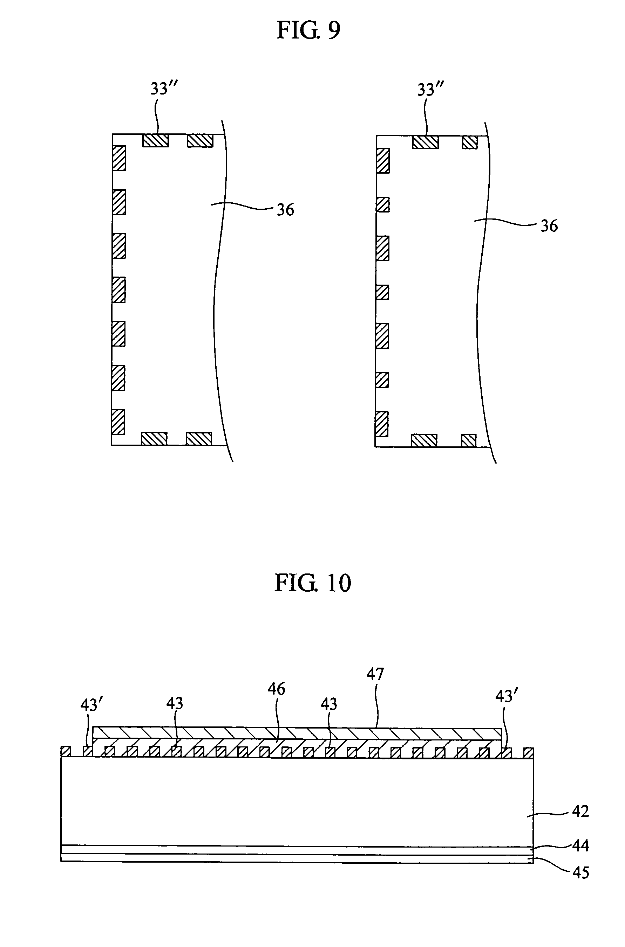

Though the exposed area of metal conductive layer 33' shows band-shaped area, the invention includes any exposed areas of metal conductive layer capable of forming electrode portion in the edges. Therefore, the exposed area of metal conductive layer 33' may be an intermittent band-shaped area in which island-shaped areas 33" are continuously provided, as shown in the partial view of Fig. 9. The shape of the island-shaped areas 33" may be any shapes such as rectangle, ellipse, circle, polygon. The sizes of island-shaped areas 33" are the same as each other or different from each other.

On the hard coat layer 36, a low refractive index layer having lower refractive index than that of the hard coat layer is preferably provided in order to enhance antireflection property. In the case, the low refractive index layer is generally formed on the whole surface of the hard coat layer. Provision of the hard coat layer and the low refractive index layer is performed by coating and (light) curing the each layer separately, or by coating and then (light) these layers at a time. Though the hard coat layer 36 is provided on the metal conductive layer, an anti-glare layer and if desired the low refractive index layer is also preferably provided on the metal conductive layer depending on desired design of the optical filter.

An example of a schematic section view of an optical filter having the structure that the low refractive index layer (antireflection layer) is further provided on the hard coat layer of the optical filter of the invention as shown in Fig. 7 is shown in Fig. 10. In Fig. 10, a mesh-shaped metal conductive layer 43, a hard coat layer 46 and a low refractive index layer 47 47 are provided on one surface of a transparent film 42 in this order, and a near-infrared absorption layer 44 and a transparent adhesive layer 45 are provided on the other surface of the transparent film 42 in this order. The area adjacent to the edge area of the surface of low refractive index layer 47 are irradiated with laser. Similarly to Fig. 7, an exposed area of metal conductive layer 43' is provided in the edge area. Any layers (e.g., high refractive index layer) provided on the hard coat layer 46 are provided on the central area and the edge area as well as the low refractive index layer. Further, openings of the mesh-shaped metal conductive layer 44 are filled with the hard coat layer. Thereby the transparency is enhanced.

In the above-mentioned structure, the location of the hard coat layer 46 and the low refractive index layer (antireflection layers) 47 may be exchanged with that of the near-infrared absorption layer 44 each other. Further, the near-infrared absorption layer 44 may be provided between the metal conductive layer 43 and the hard coat layer 46. However, the structure of Fig. 10 is advantageous in easiness of provision of ground because, after attachment of the optical filter to a display, the conductive layer is located in front side (obverse side) of the display.

The metal conductive layer 13, 23 is, for example, a mesh-shaped metal layer or metal-containing layer, a metal oxide layer (dielectric material layer), or an alternately laminated layer of metal oxide layer and metal layer. The mesh-shaped metal layer or metal-containing layer is generally a layer formed by etching method or printing method, or a metal fiber layer, whereby a low resistance can be easily obtained. The openings of the mesh-shaped metal layer or metal-containing layer are generally filled with the hard coat layer 16, 26 or the antiglare layer as mentioned above, whereby enhanced transparent can be obtained. In case the openings are not filled with the hard coat layer 16, 26, they are preferably filled with other layer, for example, a near-infrared absorption layer 14, 24 or a transparent resin layer therefor.

The low refractive index layer 27 etc. constitutes an antireflection layer. In more detail, a composite layer of the hard coat layer 16, 26 and low refractive index layer provided thereon shows efficiently antireflection effect. A high refractive index layer may be provided between the hard coat layer and low refractive index layer to further enhance the antireflection effect.

The low refractive index layer may not be provided and only the hard coat layer 16, 26, which has lower or higher (preferably lower) refractive index than that of the transparent film, may be provided. The hard coat layer 16, 26 and the antireflection layer are generally formed by application, which is preferred in view of productivity and economic efficiency.

The near-infrared absorption layer 14, 24 has function that shields (cuts) undesired light such as neon light of PDP. The layer generally contains a dye having absorption maximum of 800 to 1200nm. The transparent adhesive layer 15, 25 is generally provided to be easily attached to a display. The release sheet may be provided on the transparent adhesive layer.

The electrode portion is a metal conductive layer provided in the periphery of the optical filter, and its width (L of Fig. 3) is generally 2 to 100mm, especially preferably 5 to 50mm. The metal conductive layer preferably is a mesh-shaped metal layer.

The above-mentioned rectangle-shaped optical filter for display has one transparent film, but may have two transparent films. For example, a transparent film having an antireflection layer such as a hard coat layer and a low refractive index layer is superposed on a metal conductive layer of a transparent film having the metal conductive layer thereon (generally further having a near-infrared absorption layer, etc. on its back side) through an adhesive layer such that the back side of the former transparent film is in contact with the metal conductive layer, and the hard coat layer and antireflection layer is irradiated with laser to produce an optical filter having two transparent films. Otherwise, a transparent film having mesh-shaped metal layer, an antireflection layer such as a hard coat layer and a low refractive index layer provided in this order is superposed on a metal conductive layer of another transparent film having a near-infrared absorption layer and an transparent adhesive layer through an adhesive layer such that the back sides of the transparent films are in contact with each other. The former laminate is prepared by the present process.

Though the use of two transparent films is adopted when it is advantageous for the processing of preparation, it has disadvantage of increases of thickness and of volume.

As mentioned above, the rectangle-shaped optical filter for display having one transparent film is obtained, for example, by forming on a metal conductive layer on a whole surface of a rectangle-shaped transparent film, forming an antireflection layer such as a hard coat layer and a low refractive index layer on the metal conductive layer, and forming an exposed area of the conductive layer by laser irradiation and then forming a near-infrared absorption layer and a transparent adhesive layer on the other surface of the transparent film. The near-infrared absorption layer and a transparent adhesive layer may be formed beforehand on a surface of the transparent film. The prepared filter is designed depending on the shape of display area of front side of each display. The optical filter has a projecting electrode portion of conductive layer on its periphery, which forms an electrode portion (ground electrode) that can be easily grounded and easily attached to a display.

In the invention, the laser irradiation brings about formation of the exposed area of metal conductive layer as mentioned above. Laser usable in the invention includes any laser that is capable of removing a synthetic resin layer for a short time through burning or decomposition of the resin and gives no damage to the metal conductive layer, or that can be set in that manner. Laser irradiation technique includes line beam forming technique, laser optical branching technique, double pulse technique and combination thereof. Examples of the laser include YAG laser (double wave, threefold wave), ruby laser, excimer laser, semiconductor laser, CO₂ laser, argon laser. Preferred are YAG laser (double wave, threefold wave), semiconductor laser, CO₂ laser, because they are capable of removing a synthetic resin layer for an extremely short time through burning or decomposition of the resin. This is because their wavelengths correspond to that of the synthetic resin of the first function layer. Laser irradiation is preferably carried out under the conditions of output of 5W to 15kW, diameter focused at focal point of 0.05 to 10mm, and movement rate of 1 to 3000mm/sec.

In case of using a rectangle-shaped transparent film, each of the layers may be formed in batch wise, but it is preferred that each of the layers is formed continuously, generally in roll-to-roll method, and cut.

Materials used in the optical filter for display of the present invention are explained below.

The transparent film is generally a transparent plastic film. The materials include anything having transparency (the transparency meaning transparency to visible light).
Examples of materials of the plastic films include polyester such as polyethylene terephthalate (PET) and polybutylene terephthalate, acrylic resin such as polymethyl methacrylate (PMMA), polycarbonate (PC), polystyrene, cellulose triacetate, polyvinyl alcohol, polyvinyl chloride, polyvinylidene chloride, polyethylene, ethylene-vinyl acetate copolymer, polyvinyl butyral, metal-crosslinked ethylene-methacrylic acid copolymer, polyurethane and cellophane. Preferred are polyethylene terephthalate (PET), polycarbonate (PC), polymethyl methacrylate (PMMA), because have high resistance to processing load such as heat, solvent and bending. Especially PET is preferred because of excellent processing properties. Further though an organic dye contained in the second function layer is exposed to ultraviolet [UV] light to be likely to be reduced in durability, polyester such as PET is preferably apt to absorb such UC light.

The transparent film has generally a thickness of 1µm to 10mm, preferably 1µm to 5mm, particularly 25 to 250µm depending upon the application of the optical filter.

The metal conductive layer of the invention is set such that surface resistance value of the resultant optical filter generally is not more than 10Ω/□, preferably in the range of 0.001 to5Ω/□, especially in the range of 0.005 to5Ω/□. The mesh-shaped (lattice-shaped) conductive layer is preferred. Otherwise, the conductive layer may be a layer obtained by gas phase coating (deposition), the layer being a transparent conductive layer of metal oxide such as ITO. Further, the conductive layer may be an alternately laminated layer of a dielectric layer of metal oxide such as ITO and a metal layer of Ag (e.g., ITO/Ag/ ITO/Ag/ ITO).

The mesh-shaped metal conductive layer includes a mesh-shaped metal layer made of metal fiber or metal-coated organic fiber, a layer obtained by etching a metal (e.g., Cu) layer provided on a transparent film so as to form mesh having openings, and a layer obtained by printing an electrically conductive ink on a transparent film so as to form mesh.

The mesh of the mesh-shaped metal conductive layer preferably has line width of 1µm to 1mm and opening ratio of 40 to 95%, which generally comprises metal fiber or metal-coated organic fiber. Further preferred is a mesh having line width of 10 to 500µm and opening ratio of 50 to 95%. In the mesh-shaped metal conductive layer, line width more than 1mm brings about enhanced electromagnetic-wave shielding property, while opening ratio in reduced. Line width less than 1µm brings about reduction of the strength of the resultant mesh to render its handling difficult. Moreover, opening ratio more than 95% renders keeping of the shape of the mesh difficult, while opening ratio less than 40% brings about reductions of optical transparency and of light amount from a display.

The opening ratio (aperture ratio) of the mesh-shaped metal conductive layer means the proportion of the area of the opening portion of the layer to the projected area of the layer.

Examples of metals for the metal fiber and /or metal-coated organic fiber the mesh-shaped metal conductive layer include copper, stainless, aluminum, nickel, titanium, tungsten, tin, lead, iron, silver, carbon or alloys thereof, preferably copper, stainless or nickel.

Examples of organic materials used in the metal-coated organic fiber include polyester, nylon, polyvinylidene chloride, aramid, Vinylon, and cellulose.

In a patternwise etched conductive foil such as metallic foil, as metals for the metallic foil, copper, stainless, aluminum, nickel, iron, brass or alloys thereof, preferably copper, stainless or aluminum is used.

In case of decreasing the thickness of the foil to excess, handling of the foil and workability of pattern etching are reduced. In case of increasing the thickness to excess, a thickness of the resultant filter is increased and time period requiring for etching procedure is lengthened.
Therefore the thickness of the conductive layer preferably is in the range of 1 to 200 µm.

The etched pattern may have any shapes. For example, the metallic foil is in the form of stripe, which is obtained by forming square openings (pores) on the foil, or in the form of punching metal, which is obtained by forming circle, hexagon, triangle or ellipse openings. The pores may be regularly arranged or irregularly arranged to form a random pattern. The opening ratio (the proportion of the area of the opening portion to the projected area) of the metal foil is preferably in the range of 20 to 95%.

Besides above, material soluble in a solvent is dot-wise applied to a film to form dots, a conductive material layer insoluble in the solvent is formed on the film, and the film is brought in contact with the solvent to remove the dots and the conductive material layer provided on the dots whereby a mesh-shaped metal conductive layer can be obtained. The mesh-shaped metal conductive layer may be used in the invention.

A plated layer (metallic deposit) may be further provided on the metal conductive layer. Particularly, it is preferred to form the plated layer on the layer obtained by the formation of dots using material soluble in a solvent. The plated layer can be formed by conventional electrolytic plating and nonelectrolytic plating. Examples of metals used in the plating generally include copper, copper alloy, nickel, aluminum, silver, gold, zinc or tin. Preferred is copper, copper alloy, silver or nickel, particularly copper or copper alloy is preferred in view of economic efficiency and conductive property.

Further antiglare property may be provided to the conductive layer. In a step of the antiglare treatment, a blackened treatment may be carried out on a surface of the (mesh-shaped) conductive layer. For example, oxidation treatment of metal layer, black plating of chromium alloy, or application of black or dark color ink can be carried out.

The antireflection layer of the invention generally is a laminated layer of a hard coat layer having lower refractive index than that of the transparent film as a substrate and a low refractive index layer having lower refractive index than that of the hard coat layer; or is a laminated layer of a hard coat layer, a low refractive index and a high refractive index layer provided therebetween. The antireflection layer may be only a hard coat layer, which has antireflection effect. However, in case the transparent film has low refractive index, the antireflection layer may be a laminated layer of a hard coat layer having higher refractive index than that of the transparent film and a low refractive index layer; or a laminated layer of a hard coat layer, a low refractive index and a high refractive index layer provided thereon.

The hard coat layer is a layer mainly consisting of synthetic resin such as acrylic resin, epoxy resin, urethane resin, silicon resin, etc. The hard coat layer generally has a thickness of 1 to 50µm, preferably 1 to 10µm. The synthetic resin is generally thermosetting resin or ultraviolet curable resin, preferred ultraviolet curable resin. The ultraviolet curable resin can be cured for a short time, and hence has excellent productivity. Further it is preferably deleted easily by laser irradiation.

Examples of the thermosetting resin include phenol resin, resorcinol resin, urea resin, melamine resin, epoxy resin, acrylic resin, urethane resin, furan resin and silicon resin.

The hard coat layer preferably is a cured layer of an ultraviolet curable resin composition, which comprises ultraviolet curable resin, photopolymerization initiator, etc. The layer generally has a thickness of 1 to 50µm, preferably 1 to 10µm.

Examples of the ultraviolet curable resin s (monomers, oligomers) include (meth)acrylate monomers such as 2-hydroxyethyl (meth)acrylate, 2-hydroxyropyl (meth)acrylate, 4-hydroxybutyl (meth)acrylate, 2-ethylhexylpolyethoxy (meth)acrylate, benzyl (meth)acrylate, isobornyl (meth)acrylate, phenyloxyethyl (meth)acrylate, tricyclodecane mono(meth)acrylate, dicyclopentenyloxyethyl (meth)acrylate, tetrahydrofurfuryl (meth)acrylate, acryloylmorpholine, N-vinylcaprolactam, 2-hydroxy-3-phenyloxypropyl (meth)acrylate, o-phenylphenyloxyethyl (meth)acrylate, neopentylglycol di(meth)acrylate, neopentyl glycol dipropoxy di(meth)acrylate, neopentyl glycol hydroxypivalate di(meth)acrylate, tricyclodecanedimethylol di(meth)acrylate, 1,6-hexanediol di(meth)acrylate, nonanediol di(meth)acrylate, trimethylolpropane tri(meth)acrylate, pentaerythritol tri(meth)acrylate, pentaerythritol tetra(meth)acrylate, tris[(meth)acryloxyethyl]isocyanurate and ditrimethylolpropane tetra(meth)acrylate; and
the following (meth)acrylate oligomer such as:
polyurethane (meth)acrylate such as compounds obtained by reaction among the following polyol compound and the following organic polyisocyanate compound and the following hydroxyl-containing (meth)acrylate:
the polyol compound (e.g., polyol such as ethylene glycol, propylene glycol, neopentyl glycol, 1,6-hexanediol, 3-methyl-1,5-pentanediol, 1,9-nonanediol, 2-ethyl-2-butyl-1,3-propanediol, trimethylolpropane, diethylene glycol, dipropylene glycol, polypropylene glycol, 1,4-dimethylolcyclohexane, bisphenol-A polyethoxydiol and polytetramethylene glycol; polyesterpolyol obtained by reaction of the above-mentioned polyol with polybasic acid or anhydride thereof such as succinic acid, maleic acid, itaconic acid, adipic acid, hydrogenated dimer acid, phthalic acid, isophthalic acid and terephthalic acid; polycaprolactone polyol obtained by reaction of the above-mentioned polyol with ε-caprolactone; a compound obtained by reaction of the above-mentioned polyol and a reaction product of the above-mentioned polybasic acid or anhydride thereof and ε-caprolactone; polycarbonate polyol; or polymer polyol), and
the organic polyisocyanate compound (e.g., tolylene diisocyanate, isophorone diisocyanate, xylylene diisocyanate, diphenylmethane-4,4'-diisocyanate, dicyclopentanyl diisocyanate, hexamethylene diisocyanate, 2,4,4'-trimethylhexamethylene diisocyanate, 2,2',4-trimethylhexamethylene diisocyanate), and
the hydroxyl-containing (meth)acrylate (e.g., 2-hydroxyethyl (meth)acrylate, 2-hydroxyropyl (meth)acrylate, 4-hydroxybutyl (meth)acrylate, 2-hydroxy-3-phenyloxypropyl (meth)acrylate, cyclohexane-1,4-dimethylolmono(meth)acrylate, pentaerythritol tri(meth)acrylate or glycerol di(meth)acrylate);
bisphenol-type epoxy(meth)acrylate obtained by reaction of bisphenol-A epoxy resin or bisphenol-F epoxy resin and (meth)acrylic acid.
These compounds can be employed singly or in combination of two or more kinds. The ultraviolet curable resin can be used together with thermo polymerization initiator, i.e., these can be employed as a thermosetting resin.

To obtain the hard coat layer, hard polyfunctional monomer such as pentaerythritol tri(meth)acrylate, pentaerythritol tetra(meth)acrylate, and dipentaerythritol hexa(meth)acrylate, is preferably used in a main component.

Photopolymerization initiators can be optionally selected depending upon the properties of the ultraviolet curable resin used. Examples of the photopolymerization initiators include acetophenone type initiators such as 2-hidroxy-2-methyl-1-phenylpropane-1-on, 1-hydroxycyclohexylphenylketone and 2-methyl-1-[4-(methylthio)phenyl]-2-morphorino-propane-1-on; benzoin type initiators such as benzylmethylketal; benzophenone type initiators such as benzophenone, 4-phenylbenzophenone and hydroxybenzophenone; thioxanthone type initiators such as isopropylthioxanthone and 2,4-diethythioxanthone. Further, as special type, there can be mentioned methylphenylglyoxylate. Especially preferred are 2-hidroxy-2-methyl-1-phenylpropane-1-on, 1-hydroxycyclohexylphenylketone, 2-methyl-1-[4-(methylthio)phenyl]-2-morphorinopropane-1-on and benzophenone. These photopolymerization initiators can be employed together with one or more kinds of a conventional photopolymerization promoter such as a benzoic acid type compound (e.g., 4-dimethylaminobenzoic acid) or a tertiary amine compound by mixing with the promoter in optional ratio. Only the initiator can be employed singly or in combination of two or more kinds. Especially, 1-hydroxycyclohexylphenylketone (Irgercure 184, available from Chiba-Specialty Chemicals) is preferred.

The initiator is preferably contained in the resin composition in the range of 0.1 to 10% by weight, particularly 0.1 to 5% by weight based on the resin composition.

The hard coat layer may further contain an ultraviolet absorber, an aging resistant agent, a dye, and a processing auxiliary agent in a small amount. Particularly the layer preferably contains the ultraviolet absorber (e.g., benzotriazole ultraviolet absorber, or benzophenone ultraviolet absorber), whereby yellowing of the optical filter can be efficiently prevented. The amount generally is in the range of 0.1 to 10% by weight, preferably 0.1 to 5% by weight based on the resin composition.

The hard coat layer preferably has lower reflective index than that of the transparent film, and the use of the ultraviolet curable resin generally brings about easily the lower reflective index. Hence, as the transparent film, materials having high reflective index such as PET is preferably used. Therefore the hard coat layer preferably has reflective index of not more than 1.60. The thickness is mentioned above.

The high reflective index layer is preferably a layer (cured layer) in which conductive metal oxide particles (inorganic compound) such as ITO, ATO, Sb₂O₃, SbO₂, In₂O₃, SnO₂, ZnO, Al-doped ZnO, TiO₂ are dispersed in polymer (preferably ultraviolet curable resin). The conductive metal oxide particle generally has mean particle size of 10 to 1000nm, preferable 10 to 50nm. Especially ITO (especially mean particle size of 10 to 50nm) is preferred. The thickness generally is in the range of 10 to 500nm, preferably 20 to 200nm.

In case the high reflective index layer has conductive layer, the minimum reflectivity of the surface of the antireflection layer can be reduced to not more than 1.5% by increasing the reflective index of the high reflective index layer to not less than 1.64. Further the minimum reflectivity of the surface of the antireflection layer can be reduced to not more than 1.0% by preferably increasing the reflective index of the high reflective index layer as not less than 1.69, especially 1.69 to 1.82.

The low reflective index layer preferably a layer (cured layer) in which particles of silica or fluorine resin (preferably hollow silica) are dispersed in polymer (preferably ultraviolet curable resin). The low reflective index layer contains preferably 10 to 40 % by weight, especially 10 to 30% by weight of the particles. The low reflective index layer preferably has refractive index of 1.45 to 1.51. The refractive index of more than 1.51 brings about reduction of antireflection property of the antireflection layer. The thickness generally is in the range of 10 to 500nm, preferably 20 to 200nm.

The hollow silica preferably has mean particle size of 10 to 100nm, especially 10 to 50nm, and specific gravity 0.5 to 1.0, especially 0.8 to 0.9.

The hard coat layer preferably has visible light transmission of not less than 85%. Also, the low and high reflective index layers preferably have visible light transmission of not less than 85%.

In case the antireflection layer is composed of the hard coat layer and the above-mentioned two layers, for example, the hard coat layer has a thickness of 2 to 20µm, the high reflective index layer has a thickness of 75 to 90nm, and the low reflective index layer has a thickness of 85 to 110nm.

The provision of each of the antireflection layer can be carried out, for example, by mixing polymer (preferably ultraviolet curable resin) with if desired the above-mentioned particles, and applying the resultant coating liquid onto the rectangle-shaped transparent film, and then drying and exposed to ultraviolet rays. The layers may be applied and exposing to UV rays, respectively, or all the layers may be applied and then exposing to UV rays at one time.

The application can be carried out, for example, by applying a coating liquid (solution) of ultraviolet curable resin including acrylic monomers in a solvent such as toluene by means of gravure coater, and drying, and then exposing to UV rays to be cured. This wet-coating method enables high-speed, uniform and cheap film formation. After the coating, for example, the coated layer is exposed to UV rays to be cured whereby the effects of improved adhesion and enhanced hardness of the layer can be obtained. The conductive layer can be formed in the same manner.

In the UV- rays curing, it is possible to adopt, as light source used, various sources generating light in the wavelength range of ultraviolet to visible rays. Examples of the sources include super-high-pressure, high-pressure and low-pressure mercury lamps, a chemical lamp, a xenon lamp, a halogen lamp, a mercury halogen lamp, a carbon arc lamp, and an incandescent electric lamp, and laser beam. The exposing time is generally in the range of a few seconds to a few minutes, depending upon kinds of the lamp and strength of light. To promote the curing, the laminate may be heated beforehand for 40 to 120°C, and then the heated laminate may be exposed to ultraviolet rays.

As mentioned above, the antiglare layer is preferably formed instead of the hard coat layer, which is apt to bring about enhanced antireflection effect. The antiglare layer is preferably obtained, for example, by applying a coating liquid (solution) of transparent filler such as polymer particles (e.g., acrylic beads) preferably having mean particle size of 1 to 10m dispersed in binder and drying, or by applying a coating liquid (solution) of ultraviolet curable resin including the transparent filler such as polymer particles (e.g., acrylic beads) in materials for forming hard coat layer, and cured to have hard coat function. The antiglare layer preferably has thickness of 0.01 to 20µm.

The near-infrared absorption layer is generally obtained by forming a layer containing dye on a surface of the transparent film. The near-infrared absorption layer is prepared by applying a coating liquid comprising ultraviolet- or electron-beam- curable resin or thermosetting resin containing dye and binder resin, if desired drying and curing. Otherwise, the near-infrared absorption layer can be also prepared by applying a coating liquid containing dye and binder resin, and only drying. When the near-infrared absorption layer is used as a film, it is generally a near-infrared cut film, such as dye-containing film. The dye generally has absorption maximum in wavelength of 800 to 1200nm, and its examples include phthalocyanine dyes, metal complexes dyes, nickel dithioren complexes dyes, cyanine dyes, squalirium dyes, polymethine dyes, azomethine dyes, azo dyes, polyazo dyes, diimmonium dyes, aminium dyes, anthraquinone dyes. Preferred are cyanine dyes, phthalocyanine dyes, diimmonium dyes. These dyes can be employed singly or in combination. Examples of the binder resin include thermoplastic resin such as acrylic resin.

In the invention, a neon-emission absorption function may be given to the near-infrared absorption layer such that the near-infrared absorption layer has function for adjusting color hue. For this purpose, although a neon-emission absorption layer may be provided, the near-infrared absorption layer may contain a neon-emission selective absorption dye.

Examples of the neon-emission selective absorption dyes include cyanine dyes, squalirium dyes, anthraquinone dyes, phthalocyanine dyes, polymethine dyes, polyazo dyes, azulenium dyes, diphenylmethane dyes, triphenylmethane dyes. The neon-emission selective absorption dyes are required to have neon-emission selective absorption function at wavelength of approx. 585nm and small absorption in a wavelength range of visible light except the wavelength. Hence, the dyes preferably have absorption maximum wavelength of 575 to 595nm, and half bandwidth of absorption spectrum of 40nm or less.

In case a plurality of the absorption dyes, which include a dye for absorbing near-infrared light or a dye for absorbing neon emission light, are used in combination, if there are difficulties in terms of solubility of dyes, if there are undesirable reactions among mixed dyes, and if deterioration of thermal resistance or moisture resistance occurs, it is not necessary for all the near-infrared absorption dyes to be contained in the same layer, and the near-infrared absorption dyes may be contained in different layers in such a case.

Further, coloring materials, ultraviolet absorbers, and antioxidants may be added as long as those materials adversely affect the optical properties of the filter.

As the near-infrared absorption properties of the optical filter of the invention, the transmittance of light in a wavelength range of 850 to 1000 nm may be 20% or lower, more preferably, 15% or lower. As the selective absorption properties of the optical filter, the transmittance of light at a wavelength of 585 nm is preferably 50% or lower. In the former properties, a transmittance of light existing in the wavelength range can be reduced, the wavelength range being thought to be a cause of malfunction of remote control systems in peripheral devices. In the latter property, since orange light having peak wavelength in the range of 575 to 595 nm deteriorates color reproductivity, the wavelength of orange light can be absorbed so as to make red light more intrinsic and as a result, reproducibility of colors can be improved.

The near-infrared absorption layer generally has thickness of 0.5 to 50µm.

In case a conductive adhesive tape is attached onto the exposed area of the metal conductive layer, as the conductive adhesion tape, a tape having a metal foil and an adhesion layer having electrically conductive particle dispersed in the layer provided on one side of the foil can be used. For forming the adhesion layer, adhesives such as acrylic adhesive, rubber adhesive and silicone adhesive, or epoxy resin or phenol resin containing hardening agent can be used.

As the electrically conductive particle, any materials showing good electrical conductivity can be used. Examples include metallic powder such as copper, silver, nickel powder, and resin or ceramic powder coated with the metal. Further the shape of the electrically conductive particle is also not restricted. Optional shape such as scale, arborization, grain, and pellet can be adopted.

The electrically conductive particle is generally used in the amount of 0.1 to 15% by volume based on polymer of the adhesion layer, and the mean particle size preferably is in the range of 0.1 to 100µm. The use of the particle specified in the used amount and particle size brings about prevention of aggregation of the conductive particles to provide good conductivity.

As the metallic foil as substrate of the conductive adhesive tape, a foil of metal such as copper, silver, nickel, aluminum, stainless can be used. The thickness generally is in the range of 1 to 100µm.

The adhesion layer can be easily formed by applying a mixture of the adhesive and the conductive particle in a predetermined ratio onto the metal foil by means of roll coater, die coater, knife coater, mica bar coater, flow coater, spray coater.

The thickness of the adhesion layer generally is in the range of 5 to 100µm.

Instead of the conductive adhesion tape, an adhesive made of materials constituting the adhesion layer mentioned above may be applied to the exposed area of the metal conductive layer, and a conductive tape (metal foil) may be attached to the adhesive.

The transparent adhesive layer of the invention is used to bond the optical filter of the invention to a display, and therefore any resin having adhesion function can be used as materials for forming the transparent adhesive layer. Examples of the materials include acrylic adhesives made of butyl acrylate and the like, rubber adhesives, TPE (thermoplastic elastomer) adhesives comprising as main component TPE such as SEBS (styrene/ethylene/butylene/styrene) and SBS (styrene/ butadiene/styrene).

The thickness of the transparent adhesive layer generally is in the range of 5 to 500µm, preferably in the range of 10 to 100µm. The optical filter can be generally attached to a glass plate of a display through the transparent adhesive layer.

In case of using two transparent films in the invention, examples of materials (adhesives) used in the adhesion of the films include ethylene/vinyl acetate copolymer, ethylene/methyl acrylate copolymer, acrylic resin (e.g., ethylene/(meth)acrylic acid copolymer, ethylene/ethyl (meth)acrylate copolymer, ethylene/methyl (meth)acrylate copolymer, metal-ion crosslinked ethylene/(meth)acrylic acid copolymer), and ethylene copolymers such as partially saponified ethylene/vinyl acetate copolymer, carboxylated ethylene/vinyl acetate copolymer, ethylene/(meth)acrylic acid/maleic anhydride copolymer, ethylene/vinyl acetate/ ethylene/(meth)acrylate copolymer. The (meth)acrylic acid means acrylic acid and methacrylic acid and the (meth)acrylate means acrylate and meth acrylate. Besides these polymers, there can be mentioned polyvinyl butyral (PVB) resin, epoxy resin, phenol resin, silicon resin, polyester resin, urethane resin, rubber adhesives, thermoplastic elastomer (TPE ) such as SEBS (styrene/ethylene/butylene/styrene) and SBS (styrene/ butadiene/styrene). The acrylic adhesives and epoxy resins are preferred because they show excellent adhesion.

The thickness of the above-mentioned adhesive layer generally is in the range of 10 to 50µm, preferably in the range of 20 to 30µm. The optical filter can be generally attached to a glass plate of a display through the adhesive layer under heating.

In case EVA (ethylene/vinyl acetate/ ethylene copolymer) is used as materials of the transparent adhesive layer, EVA generally has the content of vinyl acetate in an amount of 5 to 50 % by weight, especially 15 to 40 % by weight. When the content is less than 5 % by weight, the layer does not show satisfactory transparency. On the other hand, when the content is more than 50 % by weight, the layer extremely reduces in mechanical strength not to increase difficulty of film formation and occurrence of blocking between films.

As a crosslinking agent for thermo crosslinking, an organic peroxide is generally suitable. The organic peroxide is selected in the consideration of sheet-processing temperature, curing (bonding) temperature, and storage stability. Examples of the organic peroxide include 2,5-dimethylhexane-2,5-dihydroperoxide, 2,5-dimethyl-2,5-(t-butylperoxy)hexyne-3, di-t-butylperoxide, t-butylcumyl peroxide, 2,5-dimethyl-2,5-di(t-butylperoxy)hexane, dicumyl peroxide, α,α'-bis(t-butylperoxyisopropyl)benzene, n-butyl-4,4-bis(t-butylperoxy)valerate, 2,2-bis(t-butylperoxy)butane, 1,1-bis(t-butylperoxy)cyclohexane, 1,1-bis(t-butylperoxy)-3,3,5-trimethylcyclohexane, t-butylperoxybenzoate, benzoyl peroxide, t-butylperoxyacetate, methyl ethyl ketone peroxide, 2,5-dimethylhexyl-2,5-bisperoxybenzoate, butyl hydroperoxide, p-menthane hydroperoxide, p-chlorobenzoyl peroxide, t-butylperoxyisobutylate, hydroxyheptyl peroxide and chlorohexanone peroxide. The organic peroxide can be used singly, or in combination of two or more kinds. The content of the organic peroxide is generally used in an amount of not more than 5 parts by weigh, preferably 0.5 to 5 parts by weight based on 100 parts by weight of EVA.

The organic peroxide is generally kneaded with EVA by means of an extruder or roll mill. However it may be solved in an organic solvent, plasticizer, vinyl monomer and added to an EVA film by means of impregnation method.

The EVA may contain acryloyl group-containing compounds, methacryloyl group-containing compounds, allyl group-containing compounds for improvement of various properties of EVA (e.g., mechanical strength, optical characteristics, adhesive property, weather resistance, whitening resistance, rate of crosslinking).
Examples of the acryloyl and methacryloyl group-containing compounds include generally derivatives of acrylic acid or methacrylic acid, such as esters and amides of acrylic acid or methacrylic acid. Examples of the ester residue include linear alkyl groups (e.g., methyl, ethyl, dodecyl, stearyl and lauryl), a cyclohexyl group, a tetrahydrofurfuryl group, an aminoethyl group, a 2-hydroxyethyl group, a 3-hydroxypropyl group, 3-chloro-2-hydroxtpropyl group. Further, the esters include esters of acrylic acid or methacrylic acid with polyhydric alcohol such as ethylene glycol, triethylene glycol, polypropylene glycol, polyethylene glycol, trimethylol propane or pentaerythritol. Example of the amide includes diacetone acrylamide.

Examples of the esters include polyfunctional esters of acrylic acids or methacrylic acids with polyhydric alcohol such as glycerol, trimethylol propane or pentaerythritol; and further allyl group-containing compounds such as triallyl cyanurate, triallyl isocyanurate, diallyl phthalate, diallyl isophthalate and diallyl maleate. The compounds can be used singly, or in combination of two or more kinds. The content of the compound is generally used in an amount of 0.1 to 2 parts by weight, preferably 0.5 to 5 parts by weight based on 100 parts by weight of EVA.

In case EVA is cured by light, sensitizer (photoinitiator) is used instead of the organic peroxide, and it is generally used in an amount of not more than 5 parts by weigh, preferably 0.1 to 3.0 parts by weight based on 100 parts by weight of EVA.

Examples of the sensitizer include benzoin, benzophenone, benzoyl methyl ether, benzoin ethyl ether, benzoin isopropyl ether, benzoin isobutyl ether, dibenzyl, 5-nitroacenaphtene, hexachlorocyclopentadiene, p-nitrodiphenyl, p-nitroaniline, 2,4,6-trinitroaniline, 1,2-benzanthraquinone, 3-methyl-1,3-diaza-1,9-benzanthrone. The photoinitiators can be used singly, or in combination of two or more kinds.

In the invention, a silane coupling agent may be used to accelerate adhesion. Examples of the silane coupling agent include vinylethoxysilane, vinyltris(β-methoxyethoxy)silane, γ-(methacryloxypropyl)trimethoxysilane, vinyltriacetoxysilane, γ-glycidoxypropyltrimethoxysilane, γ-glycidoxypropyltriethoxysilane, β-(3,4-epoxycyclohexyl)ethyltrimethoxysilane, γ-chloropropylmethoxysilane, vinyltrichlorosilane, γ-mercaptopropylmethoxysilane, γ-aminopropyltriethoxysilane, N-β-(aminoethyl)-γ-aminopropyltrimethoxysilane.

The silane coupling agent can be used singly, or in combination of two or more kinds. The content of the silane coupling agent is generally in an amount of 0.01 to 10 parts by weight, preferably 0.01 to 5 parts by weight based on 100 parts by weight of EVA.

The EVA adhesive layer of the invention can further contain a small amount of ultraviolet absorbing agent, infrared absorbing agent, age stabilizer (antioxidant), paint processing aid and colorant. If appropriate, filler such as carbon black, hydrophobic silica or calcium carbonate may be contained.

The adhesive layer for adhesion can be obtained, for example, by mixing EVA with the above-mentioned additives and kneaded by means of extruder or roll, and then forming the sheet having the predetermined shape by film formation method using calendar, roll, T-die extrusion or blowing.

A protective layer may be provided on the antireflection layer. The protective layer is preferably formed in the same manner as that of the hard coat layer.

Materials for the release sheet provided on the transparent adhesive layer is generally transparent polymers having glass transition temperature of not less than 50°C. Examples of the materials include polyester resin (e.g., polyethylene terephthalate, polycyclohexylene terephthalate, polyethylene naphthalate), polyamide (e.g., nylon 46, modified nylon 6T, nylon MXD6, polyphthalamide), ketone resin (e.g., polyphenylene sulfide, polythioether sulfone), sulfone resin (e.g., polysulfone, polyether sulfone), polyether nitrile, polyarylate, polyether imide, polyamideimide, polycarbonate, polymethyl methacrylate, triacetylcellulose, polystyrene or polyvinyl chloride. Of these resins, polycarbonate, polymethyl methacrylate, polyvinyl chloride, polystyrene and polyethylene terephthalate can be preferably employed. The thickness is generally in the range of 10 to 200µm, especially in the range of 30 to 100µm.

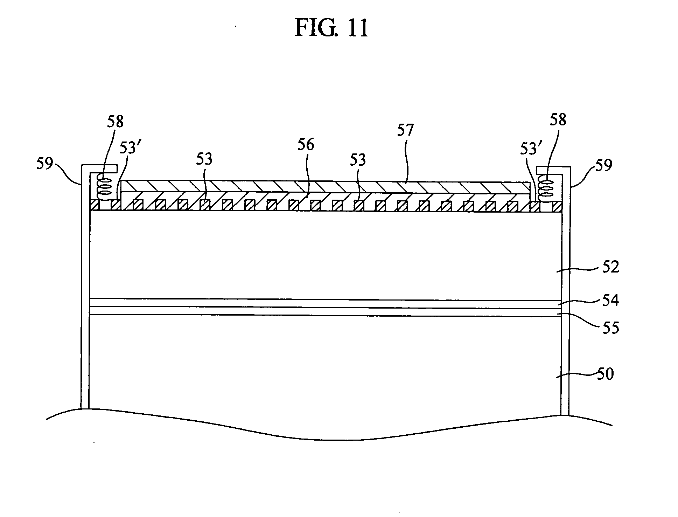

A schematic section view showing an example of the condition that the optical filter is attached onto an image display surface of a plasma display panel as one kind of display is shown in Fig. 11. The optical filter is attached onto the image display surface of the plasma display panel 50 through the transparent adhesive layer 55. In more detail, the optical filter is provided on the image display surface of the plasma display panel 50, the optical filter having a structure that a mesh-shaped metal conductive layer 53, a hard coat layer 56 and an antireflection layer 57 such as a low refractive index layer are provided on one surface of a transparent film 52 in this order, and a near-infrared absorption layer 54 and a transparent adhesive layer 55 are provided on the other surface of the transparent film 52 in this order. Further, a mesh-shaped metal conductive layer 53' is exposed in an edge area (edge area of side) of the filter. The exposed mesh-shaped metal conductive layer 53' is in contact with a metallic cover 59 provided on a periphery of the plasma display panel 50 through a shield finger (leaf-spring shaped metal part) 58. A conductive gasket may be used instead of the shield finger. Hence, conduction between the optical filter and the metallic cover 59 can be attained to bring about grounded condition. The metallic cover 59 may be metal rack or frame. As apparent from Fig. 11, the mesh-shaped metal conductive layer 53 is directed to viewing audience. The metallic cover 59 covers the range of from the farthest edge of the metal conductive layer 53 to 2- 20mm from the farthest edge. Otherwise, the shape of the metallic cover 59 is altered whereby the metallic cover 59 may be brought directly in contact with the metal conductive layer 53.

In the PDP of the invention, a plastic film is generally used as the transparent film, and therefore the optical filter is directly attached onto a surface of a glass plate of the PDP whereby PDP itself can be reduced in weight, thickness and cost, especially in case of using one transparent film. Further, compared with PDP having a front plate of a transparent molded body in front of the PDP, PDP provided with the optical filter of the invention enables the removal of an air layer between PDP and a filter for PDP can be removed and hence resolves the increase of visible-rays reflectivity caused by the interface reflection and the occurrence of the double reflection. Thereby PDP of the invention can be improved in visibility.

Thus, the display provided with the optical filter of the invention not only enables easy earth ground, but also brings about excellent antireflection property and antistatic property, and further almost no radiation of dangerous electromagnetic wave. Hence the PDP is easily viewable, and free from dust attachment, and therefore it is a secure display.

### EXAMPLE

The invention is illustrated in detail using the following Examples and Comparative Examples. The invention is not restricted by the following Examples.

### [Example 1]

### <Preparation of optical filter for display provided with electrode portion>

### (1) Formation of mesh-shaped metal conductive layer

On an adherability layer (polyester urethane: thickness of 20nm) of a continuous polyethylene terephthalate (PET) film having thickness of 100µm (width of 600mm, length of 100m) having the adherability layer thereon, a polyvinyl alcohol aqueous solution (20%) was printed in dot pattern. A shape of each of the dots is square having a side of 234µm, a distance between the dots is 20µm, and the arrangement of the dots is in the form of square grid (lattice). The printed thickness is approx. 5µm after drying.

On the PET film having dot pattern, copper is vacuum-deposited to form a copper layer having mean thickness of 4µm. Subsequently, the PET film having dot pattern and copper layer was immersed in room-temperature water and the dots were dissolved and removed by rubbing with sponge, and then was rinsed with water, dried to form a mesh-shaped metal conductive layer on the whole surface of the PET film (see Fig. 1(1)).

The metal conductive layer on the PET film showed pattern of square grid (mesh) precisely corresponding to negative pattern of the dot pattern. The line width of the mesh is 20µm, and the opening ratio is 77%. Further mean thickness of the conductive layer (copper layer) is 4µm.

### (2) Formation of hard coat layer

The following composition:

| | |
|---|---|
| Dipentaerythritol hexaacrylate (DPHA) | 80 weight parts |
| ITO (Mean particle size: 150nm) | 20 weight parts |
| Methyl ethyl ketone | 100 weight parts |
| Toluene | 100 weight parts |
| Irgacure 184 | |
| (Available from Ciba specialty chemicals) | 4 weight parts |

was mixed to form a coating liquid, which was applied onto the whole surface of the mesh-shaped metal conductive layer with a bar coater (see Fig. 1(2)), and cured by UV irradiation. Hence, a hard coat layer having thickness of 5µm (refractive index: 1.52) was formed on the mesh-shaped metal conductive layer.

### (3) Formation of low refractive index layer

The following composition:

| | |
|---|---|
| Opster JN-7212 (Available from JSR) | 100 weight parts |
| Methyl ethyl ketone | 117 weight parts |
| Methyl isobutyl ketone | 117 weight parts |

was mixed to form a coating liquid, which was applied onto the surface of the hard coat layer with a bar coater, and dried in an oven at 80°C for five minutes, and then cured by UV irradiation. Hence, a low refractive index layer having thickness of 90nm (refractive index: 1.42) was formed on the hard coat layer.

### (4) Formation of near-infrared absorption layer (having color hue adjusting function)

The following composition:

| | |
|---|---|
| Polymethyl methacrylate | 30 weight parts |
| TAP-2 | |
| (Available from Yamada Chemical Co., Ltd.) | 0.4 weight part |
| Plast Red 8330 | |
| (Available from Arimoto Chemical Co., Ltd.) | 0.1 weight part |
| CIR-1085 | |
| (Available from Japan Carlit Co., Ltd.) | 1.3 weight part |
| IR-10A | |
| (Available from Nippon Syokubai Co., Ltd.) | 0.6 weight part |
| Methyl ethyl ketone | 152 weight parts |
| Methyl isobutyl ketone | 18 weight parts |

was mixed to form a coating liquid, which was applied onto the whole reverse side of the PET film with a bar coater, and dried in an oven at 80°C for five minutes. Hence, a near-infrared absorption layer provided with color hue adjusting function having thickness of 5µm was formed on the reverse side of PET film.

### (5) Formation of transparent adhesive layer

The following composition:

| | |
|---|---|
| SK Dyne 1811L (Available from | |
| Soken Chemical & Engineering Co., Ltd.) | 100 weight parts |
| Hardener L-45 (Available from Soken Chemical & Engineering Co., Ltd.) | 0.45 weight part |
| Toluene | 15 weight parts |
| Ethyl acetate | 4 weight parts |

was mixed to form a coating liquid, which was applied onto the near-infrared absorption layer with a bar coater, and dried in an oven at 80°C for five minutes. Hence, a transparent adhesive layer having thickness of 25µm was formed on the near-infrared absorption layer.

Subsequently, the edge area of the low refractive index layer of the resultant laminate was irradiated with laser using CO₂ laser processing machine under the conditions of out put of 30W, focused diameter of 0.5mm at focus position and movement rate of 100mm/sec. On the whole periphery of the low refractive index layer, an exposed area of the metal conductive layer 23' (width of 5mm) and an edge-area low refractive index layer 27' (width of 0.5mm) outside the exposed area of the metal conductive layer 23' were formed.

Thus, an optical filter for display provided with electrode portion in its periphery was obtained.

### [Example 2]

Procedures of Example 1 were repeated except that a high refractive index layer was formed between the hard coat layer and the low refractive index layer in the following manner to prepare an optical filter for display provided with electrode portion.

### (6) Formation of high refractive index layer

The following composition:

| | |
|---|---|
| Dipentaerythritol hexaacrylate (DPHA) | 6 weight parts |
| ZnO (Mean particle size: 4nm) | 4 weight parts |
| Methyl ethyl ketone | 100 weight parts |
| Toluene | 100 weight parts |
| Irgacure 184 | |
| (Available from Ciba specialty chemicals) | 1 weight part |

was mixed to form a coating liquid, which was applied onto the hard coat layer with a bar coater, and cured by UV irradiation. Hence, a high refractive index layer having thickness of 90nm (refractive index: 1.70) was formed on the hard coat layer.

### [Example 3]

Procedures of Example 1 were repeated except that the (1) Formation of mesh-shaped metal conductive layer was carried out in the following manner to prepare an optical filter for display provided with electrode portion in its both sides.

### (1) Formation of mesh-shaped metal conductive layer

Onto an adherability layer (polyester urethane: thickness of 20nm) of a continuous polyethylene terephthalate (PET) film having thickness of 100µm (width of 600mm, length of 100m) having the adherability layer thereon, a copper foil having thickness of 10µm was attached. The copper foil was subjected to pattern formation processing according to photolithographic method and an exposed area of the copper foil was etched, whereby a copper foil in the form of mesh pattern (line width of 10µm, pitch of 250µm).

Thus line width of the conductive layer (copper layer) is 10µm and the opening ratio is 90%. The mean thickness of the conductive layer (copper layer) is 10µm.

### [Example 4]

Procedures of Example 3 were repeated except that a high refractive index layer was formed between the hard coat layer and the low refractive index layer in the following manner to prepare an optical filter for display provided with electrode portion.

### (6) Formation of high refractive index layer

The following composition:

| | |
|---|---|
| Dipentaerythritol hexaacrylate (DPHA) | 6 weight parts |
| ZnO (Mean particle size: 4nm) | 4 weight parts |
| Methyl ethyl ketone | 100 weight parts |
| Toluene | 100 weight parts |
| Irgacure 184 | |
| (Available from Ciba specialty chemicals) | 1 weight part |

was mixed to form a coating liquid, which was applied onto the hard coat layer with a bar coater, and cured by UV irradiation. Hence, a high refractive index layer having thickness of 90nm (refractive index: 1.70) was formed on the hard coat layer.

### [Example 5]

Procedures of Example 3 were repeated except that an antiglare layer was formed instead of the hard coat layer in the following manner to prepare an optical filter for display provided with electrode portion.

### (2) Formation of antiglare layer

The following composition:

| | |
|---|---|
| Dipentaerythritol hexaacrylate (DPHA) | 80 weight parts |
| ITO (Mean particle size: 150nm) | 20 weight parts |
| Acrylic beads (Mean particle size: 3.5µm, Trade name: MX Series, Available from Soken Chemical & Engineering Co., Ltd.) | 10 weight parts |
| Methyl ethyl ketone | 100 weight parts |
| Toluene | 100 weight parts |
| Irgacure 184 | |
| (Available from Ciba specialty chemicals) | 4 weight part |

was mixed to form a coating liquid, which was applied onto the mesh-shaped metal conductive layer with a bar coater coater (see Fig. 1(2)), and cured by UV irradiation. Hence, a high refractive index layer having thickness of 13µm (refractive index: 1.52) was formed on the mesh-shaped metal conductive layer.

### [Example 6]

Procedures of Example 1 were repeated except that the laser irradiation was carried out in the following manner to prepare an optical filter for display provided with electrode portion.

The edge area of the periphery of the low refractive index layer of the resultant laminate was irradiated with laser using CO₂ laser processing machine under the conditions of out put of 30W, focused diameter of 0.5mm at focus position and movement rate of 100mm/sec. The laser irradiation was carried out such that the farthest edge area of the periphery of the low refractive index layer was covered with the focused area of the laser. On the whole periphery of the low refractive index layer, an exposed area of the metal conductive layer 23' (width of 5mm) was formed.

### [Estimation of optical filter]

### (1) Conductive property

A resistance meter (Trade name: Milliohm high tester; Hioki E.E. Corporation) was connected to the electrode portions (opposite two electrode portions) of the optical filter to measure resistance value.

The obtained results were shown in Table 1.

**Table 1**

| | Resistance Value |
|---|---|
| Example 1 | 150 mΩ |
| Example 2 | 150 mΩ |
| Example 3 | 130 mΩ |
| Example 4 | 130 mΩ |
| Example 5 | 130 mΩ |
| Example 6 | 150 mΩ |

Further, in case the PDP filters obtained in Examples 1 to 6 are attached onto PDP, the resultant PDPs provided with the filters favorably compare with conventional PDP in performances such as transparency and electromagnetic-wave shielding property. Furthermore, the PDP filters can be easily attached to PDP to enhance productivity of PDP.

### [Industrial applicability]

The use of the optical filter of the invention provides a display, especially PDP having excellent antireflection property, near-infrared absorption property, electromagnetic-wave shielding property.

## Claims

1. An optical filter for display comprising a structure of a metal conductive layer provided on a transparent film,
wherein a first functional layer is provided on the metal conductive layer of the transparent film, and the metal conductive layer is exposed in at least a part of a peripheral edge area or an area adjacent to said edge area of the transparent film.

2. An optical filter for display as defined in claim 1, wherein a second functional layer is provided on a surface having no metal conductive layer of the transparent film.

3. An optical filter for display as defined in claim 1 or 2, wherein the transparent film has shape of rectangle, the metal conductive layer is provided on a whole surface of the transparent film, the first functional layer is provided on an area except edge area of at least both sides of the metal conductive layer, and the metal conductive layer is exposed in the edge area of both sides.

4. An optical filter for display as defined in claim 1 or 2, wherein the transparent film has shape of rectangle, the metal conductive layer is provided on a whole surface of the transparent film, a band-shaped first functional layer is provided on an edge area of at least both sides of the metal conductive layer, a band-shaped metal conductive layer having no first functional layer is exposed in an adjoining area inside the band-shaped first functional layer, and the first functional layer is provided on a central portion surrounded by the band-shaped exposed metal conductive layer.

5. An optical filter for display as defined in any of claims 1 to 4,
wherein the exposed metal conductive layer is a continuous band-shaped area, or an intermittent continuous band-shaped area consisting of island-shaped conductive layers interrupted by the first functional layer.

6. An optical filter for display as defined in any of claims 3 to 5,
wherein the exposed metal conductive layer is formed in an edge area of four sides of the first functional layer to have shape of frame.

7. An optical filter for display as defined in any of claims 3 to 6,
wherein the exposed metal conductive layer is an intermittent continuous band-shaped area consisting of island-shaped conductive layers interrupted by the first functional layer, shapes of the island-shaped conductive layers being the same as or different from each other.

8. An optical filter for display as defined in any of claims 1 to 7,
wherein the metal conductive layer is a mesh-shaped metal conductive layer.

9. An optical filter for display as defined in any of claims 1 to 8,
wherein the first functional layer is a hard coat layer.

10. An optical filter for display as defined in any of claims 1 to 8,
wherein the first functional layer comprises a hard coat layer and a low refractive index layer having lower refractive index than that of the hard coat layer, the hard coat layer being in contact with the metal conductive layer.

11. An optical filter for display as defined in any of claims 1 to 8,
wherein the first functional layer comprises a hard coat layer, a high refractive index layer having higher refractive index than that of the hard coat layer and a low refractive index layer having lower refractive index than that of the hard coat layer, the hard coat layer being in contact with the metal conductive layer.

12. An optical filter for display as defined in any of claims 1 to 8,
wherein the first functional layer is an anti-glare layer.

13. An optical filter for display as defined in any of claims 1 to 8,
wherein the first functional layer comprises an anti-glare layer and a low refractive index layer having lower refractive index than that of the anti-glare layer, the anti-glare being in contact with the metal conductive layer.

14. An optical filter for display as defined in any of claims 2 to 13,
wherein the second functional layer is at least one layer selected from a near-infrared absorption layer, a neon-cut layer and a transparent adhesive layer.

15. An optical filter for display as defined in any of claims 2 to 14,
wherein the second functional layer comprises a transparent adhesive layer having near-infrared absorption function and neon-cut function.

16. An optical filter for display as defined in any of claims 2 to 14,
wherein the second functional layer comprises a near-infrared absorption layer having neon-cut function and a transparent adhesive layer, superposed in this order on the transparent film.

17. An optical filter for display as defined in any of claims 2 to 14,
wherein the second functional layer comprises a near-infrared absorption layer and a transparent adhesive layer having neon-cut function, superposed in this order on the transparent film.

18. An optical filter for display as defined in any of claims 2 to 14,
wherein the second functional layer comprises a near-infrared absorption layer, a neon-cut layer and a transparent adhesive layer, superposed in this order on the transparent film.

19. An optical filter for display as defined in any of claims 1 to 18, which is an optical filter for plasma display panel.

20. An optical filter for display as defined in any of claims 1 to 18, which is attached onto a glass plate.

21. A process for the preparation of an optical filter for display having a protruding conductive layer in its periphery as an electrode portion, comprising:
prising:
a step of irradiating with laser at least a part of a periphery edge area or an area adjacent to said edge area of a first functional layer of a laminate, the laminate comprising a transparent film, a metal conductive layer provided on a whole surface of the transparent film and the first functional layer provided on a whole surface of the metal conductive layer, to remove the irradiated portion of the first functional layer whereby the metal conductive layer is exposed in the portion.

22. A process for the preparation of an optical filter for display having a protruding conductive layer in its periphery as an electrode portion, comprising:
a step of irradiating with laser an edge area or an area adjacent to said edge area of at least both sides of a rectangle-shaped first functional layer of a laminate, the laminate comprising a rectangle-shaped transparent film, a metal conductive layer provided on a whole surface of the transparent film and the first functional layer provided on a whole surface of the metal conductive layer, to remove the irradiated portion of the rectangle-shaped first functional layer whereby a band-shaped metal conductive layer is exposed in the edge area or areas adjacent to said edge area of at least both sides of the rectangle-shaped first functional layer.

23. A process for the preparation of an optical filter for display having a protruding conductive layer in its periphery as an electrode portion, comprising:
a step of irradiating with laser an edge area or an area adjacent to said edge area of all four sides of a rectangle-shaped first functional layer of a laminate, the laminate comprising a rectangle-shaped transparent film, a metal conductive layer provided on a whole surface of the transparent film and the first functional layer provided on a whole surface of the metal conductive layer, to remove the irradiated portion of the first functional layer whereby a frame-shaped metal conductive layer is exposed in the edge area or the area adjacent to the edge area of the rectangle-shaped first functional layer.

24. A process for the preparation of an optical filter for display as defined in any of claims 21 to 23, wherein a second functional layer is provided on a surface having no metal conductive layer of the transparent film.

25. A process for the preparation of an optical filter for display as defined in any of claims 21 to 24, wherein the irradiation of the laser is carried out continuously or intermittently.

26. An optical filter for display obtained by the process for the preparation of an optical filter for display as defined in any of claims 21 to 25.

27. An optical filter for display obtained by the process for the preparation of an optical filter for display as defined in any of claims 21 to 25, which is attached onto a glass plate.

28. A display provided with an optical filter for display as defined in any of claims 1 to 20, 26 and 27.

29. A plasma display panel provided with an optical filter for display as defined in any of claims 1 to 20, 26 and 27.
